(19) **Europäisches Patentamt / European Patent Office / Office européen des brevets**

(11) **EP 4 764 696 A1**

(12) # EUROPEAN PATENT APPLICATION

(43) Date of publication:
**24.06.2026 Bulletin 2026/26**

(21) Application number: **24221119.1**

(22) Date of filing: **18.12.2024**

(51) International Patent Classification (IPC):
**G03F 1/60** *(2012.01)*        **G03F 1/72** *(2012.01)*
**G03F 1/84** *(2012.01)*

(52) Cooperative Patent Classification (CPC):
**G03F 1/60; G03F 1/72; G03F 1/84**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicants:
• **Carl Zeiss SMT GmbH**
  **73447 Oberkochen (DE)**
• **Carl Zeiss SMS Ltd.**
  **2015600 Misgav (IL)**

(72) Inventors:
• **ELJARRAT ASCUNCE, Alberto**
  **07745 Jena (DE)**
• **VAN DRIEL, Martin**
  **07745 Jena (DE)**
• **DMITRIEV, Vladimir**
  **2015600 Misgav (IL)**
• **UMLAUFT, Jonas**
  **07745 Jena (DE)**
• **SEESSELBERG, Markus**
  **73447 Oberkochen (DE)**

(74) Representative: **Bardehle Pagenberg Partnerschaft mbB Patentanwälte Rechtsanwälte Prinzregentenplatz 7 81675 München (DE)**

(54) **METHOD AND APPARATUS FOR CORRECTING AN OPTICAL ELEMENT WITH INHOMOGENEOUS MATERIAL PROPERTIES**

(57)     A method 700, a computer program, and an apparatus 400 for correcting an error of a mask substrate using a plurality of laser pulses applied on a plurality of positions on the mask substrate is provided. The method comprises:

receiving 720 a refractive index map of the mask substrate,

receiving 730 mask substrate error information,

determining 740 at least one first laser parameter for each of the plurality of laser pulses and/or the plurality of positions,

wherein the determining is based on the refractive index map and the mask substrate error information.

Fig. 4

Processed by Luminess, 75001 PARIS (FR)

EP 4 764 696 A1

**Description**

**1. Field of the invention**

The present invention generally relates to the field of correcting an error of a mask using a plurality of laser pulses, wherein a substrate of the mask may have inhomogeneous material properties. Specifically, the laser pulses may locally deform the substrate of the mask such that bending errors and/or positioning errors of pattern elements and/or other elements on the mask may be corrected. The aspects may for example be applied to masks of EUV, DUV or generally optical lithography masks, nanoimprint lithography templates or other elements, such as masks or mask substrates in general, wafers, etc., e.g. to correct bending errors and/or positioning errors on the substrates, wafers, etc.

**2. Background of the invention**

As a result of a constantly increasing integration density in the semiconductor industry, masks must project smaller and smaller structures onto a photosensitive layer, e.g., a photoresist on wafers. To fulfil this demand, the exposure wavelength of masks has been shifted to smaller wavelengths, and in particular to the extreme ultraviolet (EUV) wavelength range of the electromagnetic spectrum (e.g. in the range of 10 nm - 15 nm).

Particularly, for these short wavelength ranges, masks must fulfil highest demands with respect to e.g. phase or amplitude errors, planarity, etc. The tolerable deviation of their substrates from the planarity is only a portion of a wavelength of the exposure wavelength to not significantly disturb the phase front of the electromagnetic wave reflected from a multi-layer structure on a surface of the substrate. Larger deviations may lead to variations of the optical intensity distribution in the photoresist due to a constructive or a destructive superposition of the wavefront in the photoresist. Similarly, placement errors of pattern elements may lead to errors, even if the errors are minor.

Due to both manufacturing costs and quality requirements, it is desirable to repair or modify masks, for example by increasing the planarity or correcting positions of pattern elements. To this end the application of laser pulses has been used for correcting masks. While the approaches used so far have proven as extremely powerful tools for repair, there is a desire to render these approaches even more robust and even more precise to expand the possible range of errors that may be corrected.

**3. Summary of the invention**

The above desire is met at least in part by the examples outlined herein.

In a first example, a method for correcting an error of a mask using a plurality of laser pulses applied on a plurality of positions on the substrate of the mask is provided. The method comprises receiving a refractive index map of the substrate of the mask. The method further comprises receiving mask error information. The method may further comprise determining at least one first laser parameter for each of the plurality of laser pulses and/or the plurality of positions. The determining may be based on the refractive index map and the mask error information.

Basing the determining step on the refractive index map may have the advantage that the correctional measures by the laser pulses take into account the effect of local variations of the refractive index of the substrate of the mask on the laser pulses. It has indeed turned out that the precision of the known approaches is so advanced that, in some cases, it is limited by (even minute) variations in the refractive index of a mask substrate that has previously been seen as a medium with a level of homogeneity in its refractive index. By using the (intrinsic) local variations of the refractive index as an input for determining, e.g. optimized pulse positions and/or parameters, the repair can be even more precise and tailored to the individual mask substrate and the varying refractive index variations that these may have.

The local variations of the refractive index may be taken into account when determining (optimized) positions for the laser pulses. For example, a distance between adjacent laser pulses may be varied depending on the local refractive index (variation) at the region of the two adjacent laser pulses.

In yet other examples, the local variations may be taken into account when determining the laser parameters. For example, the mask error may require a certain focal shape of a pulse at a certain position, which is however deformed from its intended shape by local refractive index variations (e.g., leading to a lens effect, an astigmatism, coma, etc.). By taking into account this variation, e.g., by the refractive index map, the focal shape may be adjusted locally, such that despite the local refractive index variations, the actual laser pulse arriving in the substrate has the desired focal shape and thus generates the required local deformation.

A map, for example the refractive index map of the substrate of the mask, may generally ascribe the substrate of the mask with at least two refractive index values at least at two different positions. In some examples, it may comprise at plurality of refractive index values for a plurality of positions, e.g., on a regular grid. In some examples, the refractive index map may be a two-dimensional map, e.g. as a function of coordinates on the surface of the substrate. This may lead to good results, when the substrate of the mask shows little variation of the refractive index with the depth of the material. In other examples, the map may be a three-dimensional map, also for example being a function of a depth within the substrate.

The mask error information may comprise deformation information and/or alignment information, for example alignment information relating to a pattern (e.g., of pattern elements) on the substrate of the mask's surface. The error information may be provided in form of a scalar and/or a vector field, for example, describing geometric deviations of the mask or the substrate of the mask compared to an ideal or desired form. It may be local error information in form of a 2D and/or a 3D map. The deformation may for example be disadvantageous in terms of on-product overlay (OPO) which may be a measure of how well different layers of a chip are aligned between each other. Also, the deformation may concern a spacing of features in one layer which may need to be corrected, e.g. such as to ensure uniformity of critical dimension.

Methods for correcting an error of a mask are for example known from DE 10 2011 083 774 A1 and WO 2013/030820 A1 which are incorporated by reference in their entirety herein. As described in these references, using a plurality of laser pulses applied on a plurality of positions on the substrate of the mask may allow to at least partially correct mask errors. To this end, the plurality of positions and/or laser parameters, for example the first laser parameter, can be selected based on the mask errors.

Laser parameters, for example the at least one first laser parameter, may be properties of the laser pulse, for example number of pulses, pulse duration, pulse power, pulse polarization, numerical aperture, beam shape on the substrate of the mask, focal depth etc.

The plurality of positions may be defined as lateral positions on the substrate of the mask, e.g., as (x, y) coordinates on the substrate of the mask. The positions may be 2D dimensional positions, wherein a first plurality of positions may be associated with a first focal depth, a second plurality of positions may be associated with a second focal depth, etc. (also referred to as writing depth). In some examples, the plurality of positions may be defined in terms of respective densities of laser pulses per area cell of the substrate of the mask. An area cell may be an area unit into which the substrate of the mask is conceptually divided.

The method may comprise: applying the plurality of laser pulses with the at least one first laser parameter for each pulse on the plurality of positions on the substrate of the mask.

Applying the plurality of laser pulses may have the effect that the error of the mask, as described by the mask error information, is at least partially corrected. Specifically, each laser pulse may induce a local deformation, wherein all local deformations together lead to the desired error correction. The quality of this correction may be improved compared to other methods which do not take the refractive index map into account.

The method may comprise receiving at least one second laser parameter for each of the plurality of laser pulses. The at least one first laser parameter and/or the plurality of positions may be further determined based on the at least one second laser parameter. In some examples, the at least one second laser parameter may comprise a focal depth of a pulse (assuming a homogenous refractive index medium), a numerical aperture of a pulse, a pulse diameter and/or shape on the substrate surface, a focal shape (assuming a homogeneous refractive index medium). The at least one second laser parameter may in some examples be a fixed parameter that is used for determining the at least one first laser parameter and/or the plurality of positions.

In some examples, the at least one second laser parameter may be the same for each of the plurality of pulses. For example, it may not be based on the refractive index map. In some examples, the at least one second laser parameter may be determined based at least in part on the mask error information, e.g. such as to optimize repair (assuming a homogeneous refractive index). The latter may allow using known techniques for determining the at least one second laser parameter, e.g. assuming a homogeneous medium. The method may then allow subsequently optimizing positions and/or the first laser parameters based on the refractive index map. Notably, the at least one first laser parameter may comprise the at least second laser parameter, wherein a value assigned to that at least one second parameter is altered/optimized when determining the at least one first laser parameter. In other examples, the at least one second laser parameter may be fixed, and the at least one first laser parameter that is determined relates to a different parameter.

Additionally or alternatively, the method may comprise receiving a second plurality of positions on the substrate of the mask. The second plurality of positions may be determined based on the mask error information. The second plurality of positions may not depend on the refractive index map. The plurality of positions and/or the at least one first laser parameter may be determined based on the second plurality of positions. For example, the second positions may be the result of an optimization based on known techniques that do not take into account the refractive index map. The first positions may then be determined, e.g., using the second positions as a starting point for optimization. In other examples, the second positions may be kept fixed as the first positions and merely the at least one first pulse parameter may be determined such as to optimize the repair based on the refractive index map.

Not taking into account the refractive index map when determining the at least one second laser parameter and/or the second plurality of positions may have the advantage that the computational effort required for the determination may be reduced. Using the at least one second laser parameter and/or the second plurality of positions for determining the at least one first laser parameter and/or the plurality of positions may have the advantage that the determining the at least one first laser parameter and/or the plurality of positions may be simplified. As outlined, in some examples, the at least one second laser parameter and/or the second plurality of positions is used as a starting point for determining the at least one first laser parameter and/or the plurality of positions.

Determining the at least one first laser parameter may further comprise determining, for each position of the plurality of positions and/or of the second plurality of positions, a local optical path difference, OPD, wherein the local OPD is caused by deviations in the refractive index map from an average refractive index of the substrate of the mask. Describing the variations of the refractive index in terms of a local optical path difference, OPD, may simplify the description of the underlying physical problem and allow for easier corrections. This will be further detailed below. For example, for a grid of potential positions, an OPD may be determined which can then be used to determine the impact of the local refractive index variation on a pulse applied at that position, e.g. on the focal shape and/or focal position (e.g. a deviation from an ideal focal shape and/or focal position expected for a perfectly homogenous medium). This may then be used in an optimization to vary the pulse properties and/or positions such as to achieve overall optimization of the repair.

Determining the local OPD may include raytracing of a laser pulse to be applied on the respective position based on the refractive index map.

For example, the OPD at a given position x, y may be determined based at least in part on the formula

$$OPD(x, y) = \int \Delta n(x, y) ds \quad ,$$

wherein $n_0$ is an average refractive index of the substrate of the mask, $\Delta n$ is the refractive index map describing the deviation of the local refractive index from the average refractive index and wherein the differential ds is the differential along the ray path obtained via raytracing of the laser pulse.

This may allow to take the propagation of the laser pulse and the refractive index observed by the laser pulse while propagating through the substrate of the mask into account. In some examples, a high accuracy of the description may be achieved when describing the refractive index map in two dimensions. In some examples, homogeneity of the refractive index for a depth coordinate of the substrate of the mask may be assumed. In other examples, a three-dimensional refractive index map may be used for ray-tracing.

For each position, the determining of the local OPD may include integrating the local phase difference for a plurality of local pulse coordinates around a center of each pulse, acquired by propagation from that local pulse coordinate to a corresponding focal depth $z_0$ within the substrate of the mask. For example, a pulse may comprise a Gaussian shape when impinging on the substrate of the mask surface. For example, two local coordinates may define a position within the Gaussian pulse on the surface. For each position, the refractive index map may be integrated to the (planned) focus of the pulse in a certain focal depth $z_0$. Hence, for each local coordinate on the surface, a corresponding OPD may be determined. For the calculation, for example a grid of coordinate pairs may be used, e.g. a rectangular grid, a circular grid. In general, a grid may follow the shape of the pulse cross-section, such as elliptical, etc.

Using local pulse coordinates may have the advantage that the description of the problem may be simplified. Further, using this description may simplify compensating the effect of the refractive index inhomogeneity of the substrate of the mask by an apparatus.

In some examples, the integrating may use a two-dimensional refractive index map.

In other examples, the refractive index map may also include the contribution of the average refractive index. In further examples, other coordinate systems may be used. According to an aspect, the integration for a certain local coordinate to the focus depth takes into account the path of a ray on its way from the local coordinate to the focus depth.

Each local OPD may comprise a set of decomposition weights for Zernike polynomials. Using decomposition weights for Zernike polynomials may simplify the description of the problem. For example, instead of using the full local OPD map for each pulse position in the optimization process, only a few (lowest order) decomposition weights may be used for each pulse position, drastically reducing computational efforts. In other examples, other polynomials and/or vector spaces than Zernike polynomials may be used.

If the effect due to refractive index variations at a given position is known in terms of coefficients for Zernike polynomials, this may simplify compensation of a laser beam. For example, a configuration of correction optics, such as a pulse shaping unit, based on coefficients of Zernike polynomials may be simplified and/or yield improved results. The decomposition weights for the Zernike polynomials for each position of the plurality of positions may be obtained based on minimizing a difference between 1) a product of the decomposition weights and the corresponding Zernike polynomials and 2) the results of the integrating the local phase difference for a plurality of local pulse coordinates around a center of each pulse as described herein.

This may allow obtaining the decomposition weights in an efficient manner by an optimization method, for example by a least square optimization method. This may allow parallelization of the calculations required for obtaining the decomposition weights.

In some examples, the at least one laser parameter comprises a configuration for a first optical component for applying each of the laser pulses, such as to adjust an amplitude and/or a phase of that laser pulse to at least partially compensate an inhomogeneous refractive index of the substrate of the mask. For example, a corresponding repair apparatus may comprise a pulse shaping unit, which may adapt the pulse shape of each individual laser pulse, e.g., based on the refractive index map, in particular based on the local OPD and/or Zernike decomposition weight(s) derived therefrom. In some example, good results can be achieved using only less than the ten lowest Zernike orders.

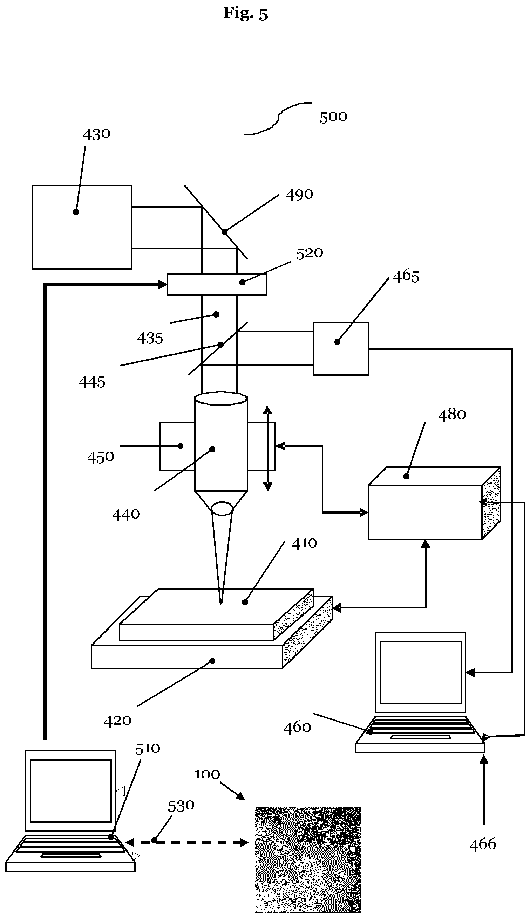

Hereby it may be possible to use the first optical component to counter the effect of the inhomogeneous refractive index to the laser pulses. Using such a first optical component may allow to decouple the problem of determining laser parameters and/or positions to compensate an error of the mask from the effects on the laser pulses created by the inhomogeneous refractive index. In these examples, the complexity of determining the correct positions and or laser parameters may be reduced. This will be detailed with reference to Fig. 5 below.

In a second example, a method is provided for correcting an error of a mask using a plurality of laser pulses on the substrate of the mask. The method may comprise receiving at least one laser parameter of the plurality of laser pulses and receiving a refractive index map of the substrate of the mask. Further, a local optical path difference, OPD, may be determined based on the at least one laser parameter, wherein the local OPD is caused by deviations in the refractive index map from an average refractive index of the substrate of the mask. In some examples, the local OPD may be used to determine pulse positions and/or parameters as described herein.

The determination of such a local OPD, preferably in the form of lowest order Zernike (or other polynomial) decomposition weights, greatly facilitates the correction of errors in a mask using laser pulses. Specifically, it allows a good compromise, taking into account the refractive index map at reasonable computation costs. The refractive index variation at each position can be taken into account, but at a level of abstraction and data reduction that speeds up the optimization of pulse coordinates and/or parameters by a large extent.

Notably, aspects outlined herein with reference to other examples may also combined with the second example.

The refractive index map of the substrate of the mask may generally be related to the plurality of positions and/or the plurality of second positions. The refractive index map of the substrate of the mask may be defined for each position of the plurality of positions and/or of the plurality of second positions.

The refractive index map of the substrate of the mask may be related to a plurality of positions such that the refractive index map allows to determine the refractive index value at each of the plurality of positions, for example by interpolation. In other examples, the refractive index map may have a higher resolution than a resolution of the plurality of positions. In these examples, for each position of the plurality of positions the refractive index is thus defined by the refractive index map.

In a third example, a computer program is provided. The computer program comprises instructions which, when the computer program is executed by a computer, cause the computer to carry out the method of the first and/or second example described herein. In a fourth example, an apparatus for correcting an error of a mask having an inhomogeneous refractive index is provided. The device comprises means for receiving a refractive index map of the substrate of the mask. Further, the device comprises means for receiving mask error information and means for determining at least one first laser parameter for each of a plurality of laser pulses and/or a plurality of positions. The determining may be based on the refractive index map and/or the mask error information.

As detailed above and as will be further detailed below, such an apparatus may enable correction of errors on masks which have an inhomogeneous refractive index.

In a fifth example, an apparatus for correcting an error of a mask is provided. The apparatus comprises a laser source for directing a plurality of laser pulses on a plurality of corresponding positions on the substrate of the mask. The apparatus may further comprise means for receiving at least one first individual laser parameter for each laser pulse of the plurality of laser pulses to be applied at a plurality of corresponding positions on the substrate of the mask. Further, the apparatus may comprise a pulse shaping unit. The pulse shaping unit may be adapted for adapting each laser pulse of the plurality of laser pulses according to the at least one first individual laser parameter for the respective laser pulse.

The apparatus according to the fifth example may allow to individually modify each laser pulse of the plurality of laser pulses for each corresponding position on the substrate of the mask. This may allow using a fixed setting of the laser source while individually modifying each individual pulse. This may increase the throughput of the system and/or simplify determination of the parameters of the plurality of laser pulses. The apparatus according to the fifth example will be further detailed below with reference to Fig. 5.

Any apparatus outlined herein may comprise means to carry out the methods outlined herein, e.g. with reference to the first and second examples.

Generally, the aspects described herein may be used as corresponding steps of a method, as computer code and/or corresponding means of an apparatus, even if not always described that way.

Moreover, the methods, the computer programs and apparatuses described herein may not only be used for masks, but also for any other suitable objects, for example wafers and the like, computer chips, etc.

The computation steps outlined herein, may be implemented in hardware or software, using one or more special purpose or general purpose computers, or processors.

## 4. Description of the drawings

In order to better understand the aspects described herein and to appreciate their practical applications, the following figures are provided and referenced hereafter. It should be noted that the figures are given as examples only and in no way limit the scope of the invention.

Fig. 1 shows schematically an example of a refractive index map.

Fig. 2a and Fig. 2b schematically exemplarily show the influence of an inhomogeneous index of refraction on an error correction process.

Fig. 3 shows schematically how the effect of an inhomogeneous refractive index can be described according to an example.

Fig. 4 depicts a schematic block diagram of an exemplary apparatus.

Fig. 5 depicts a schematic block diagram of another exemplary apparatus.

Fig. 6a show an exemplary representation of an exemplary OPD based in a Zernike decomposition.

Fig. 6b shows error metrics of the Zernike decomposition of Fig. 6a.

Fig. 7 shows an exemplary method according to the first example.

## 5. Detailed description

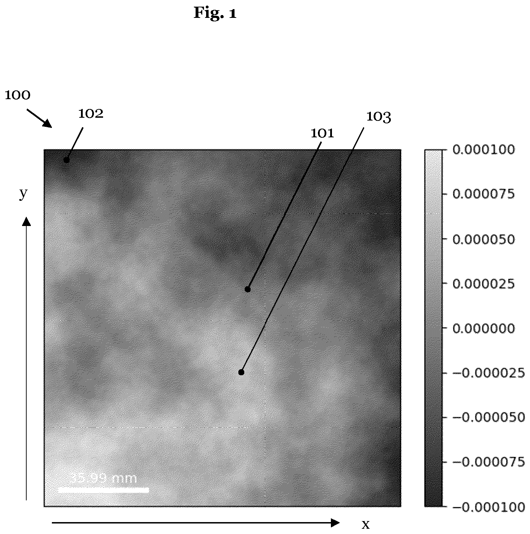

Fig. 1 shows schematically a graphical illustration of an exemplary 2D refractive index map 100. The refractive index map 100 may be a refractive index map of an optical element, for example a mask substrate.

In Fig. 1, the deviations of the local refractive index from an average refractive index of the substrate of the mask $n_o$ are shown color coded, as a function of the two-dimensional position (x, y) on the surface. In other words, in Fig. 1 the refractive index map is described in terms of a refractive index difference map $\Delta n$ (x, y) between the total refractive index map n(x, y) and the average refractive index $x_o$. In other examples, a refractive index difference map may be a difference, e.g. from a maximum refractive index or a minimum refractive index, such that the difference map may comprise all negative or all positive values. In the example of Fig. 1, the refractive index map describes the local differences between $n_o$ and the refractive index at a plurality of positions, for example positions 101, 102, 103. In the example of Fig. 1 the refractive index map is presented in two dimensions x, y in cartesian coordinates. However, other ways to describe the position are of course possible. In particular, the 2D refractive index map may be associated with an average over the entire depth of the substrate, or over the depth of the substrate from its surface to the focal plane, for example.

In other examples, the refractive index map may be three-dimensional data which also accounts for depth. For example, a 2D map as shown in Fig. 1 may be associated with a specific plane, e.g., at a certain depth, on or parallel to the substrate's surface (with several maps for different planes then forming a 3D map).

As can be seen for the plurality of positions 101, 102, 103 in Fig. 1, the refractive index shows a variation as function of position x, y. For example, on a first position 101 of the plurality of positions 101, 102, 103, the local refractive index roughly corresponds to the average refractive index $n_o$. At position 102, the local refractive index is less than the average refractive index $n_o$, while at position 103 the local refractive index has a higher value than the average refractive index $n_o$.

In the example of Fig. 1, $\Delta n$ is smaller than $10^{-4}$. However, in other regions of the same mask substrate or in different masks or different (optical) elements, the magnitude of the variations may be different.

In some examples, the map may comprise at least two data points with coordinates having a distance between them of at least 40 mm, at least 80 mm, at least 120 mm or at least 140 mm. In some examples, the data points of a refractive index map span essentially across the entire substrate surface.

In the following, the effect of a local variation in a refractive index on a laser pulse is described, for example a laser pulse used for correcting an error of a mask.

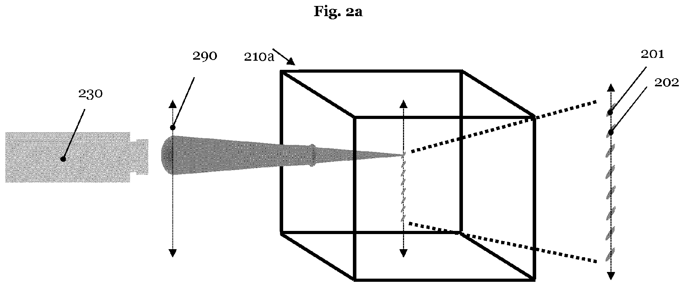

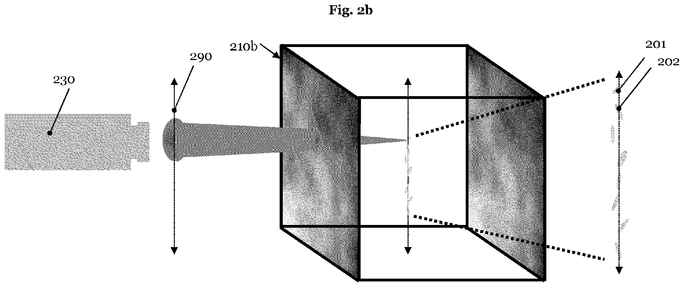

Fig. 2a and Fig. 2b schematically show the influence of an inhomogeneous index of refraction on an error correction process.

In Fig. 2a and Fig. 2b, a laser source 230 provides a plurality of laser pulses, exemplarily shown as a single pulse. For example, by a beam steering system 290, the plurality of laser pulses is focused on a plurality of positions 201, 202 inside mask substrate 210a, 210b. Additional positions of the plurality of positions are also shown in Fig. 2a and Fig. 2b on the respective axis on the right (not labeled).

In the example of Fig. 2a, mask substrate 210a has a homogenous refractive index, for example refractive index $n_o$. Laser source 230 may be operated with at least one second laser parameter for each of the plurality of laser pulses emitted by laser source 230. The at least one second laser parameter may be determined based on the mask error information, and an average refractive index $n_o$ may be used for this calculation.

In the example of Fig. 2a, mask substrate 210a has indeed a homogenous refractive index, resulting in laser foci at the plurality of planned positions at a certain focal depth, with the focus shape at each position consistent for the plurality of positions. For example, an elliptic focus with a specific tilt angle relative to the optical axis is provided. In other words, as there is no variation of the refractive index, all pulses lead to essentially the same result.

We exemplarily refer to application WO 2013/030820 A1 how such second laser parameters (also referred to as "mode signatures") can be determined for correcting errors of a mask or other optical elements.

Fig. 2b shows the scenario of Fig. 2a, when applied to a mask substrate 210b which has an inhomogeneous refractive index. Exemplarily, a map similar to that shown in Fig. 1 is assumed as a 2D map. As illustrated in Fig. 2b, if the same second laser parameters are used on mask substrate 210b, due to the variations in refractive index, the laser foci may be perturbed compared to Fig. 2a. For example, the foci may not be located in the desired focal depth but at a higher or lower depth, instead. In other examples, the shape of the focus may be perturbed, e.g., it may be more or less elliptical than desired. Still in some examples, the tilt angle may deviate from the planned angle, etc. A similar situation may arise, when the refractive index varies in all three dimensions.

As a result, and as shown in Fig. 2b, the perturbation of the laser foci may counteract the desired error correction leading to a result that is less than optimal. These deviations can be greatly reduced when taking the inhomogeneity of the substrate into account, such that the quality of error correction in masks or optical elements with inhomogeneous refractive index as for example mask substrate 210b can be greatly improved. This may be particularly relevant for mask substrate materials for EUV lithographic applications, for example doped glass for EUV lithographic applications.

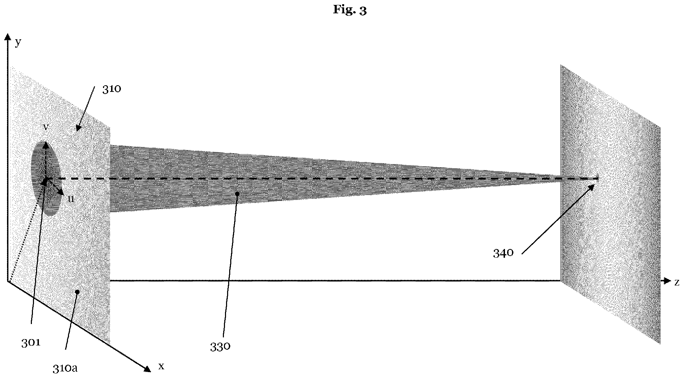

Next, a way to describe the effect of the inhomogeneities on laser pulses is illustrated. Fig. 3 shows schematically how the effect of an inhomogeneous refractive index can be described, according to an example.

As shown in Fig. 3, a laser pulse 330 may impinge on a mask substrate 310 with an inhomogeneous refractive index. As shown in Fig. 3, a first laser pulse impinges onto surface 310a of the substrate of the mask at a first (center) position 301 with coordinates x and y. The description applies similarly to a plurality of other positions $x_i$, $y_i$ onto which a pulse may impinge.

The laser at the first position 301 may be focused onto a focus point 340, e.g. at a certain depth within the substrate. The laser pulse 330 may be described in terms of pulse coordinates u and v as known in the art on the surface of the substrate 310a. For example, the pulse may comprise a certain cross section. In the example of Fig. 3, the pulse has a circular cross section, but other cross sections are of course possible. For one or more selected coordinates (u, v), the beam may propagate, following a certain ray, to the focal plane. On its way to the focus, each ray may pick up a varying phase difference and/or optical path difference that may both generally be described as optical path difference (OPD), herein.

The raytracing for determining the OPD may at least in part based on the formula

$$OPD(x, y) = \int \Delta n(x, y) ds$$

,

wherein $n_o$ is an average refractive index of the substrate of the mask,

$\Delta n$ is the refractive index map describing the deviation of the local refractive index from the average refractive index and
wherein the differential ds is the differential along the ray path obtained via the raytracing of the laser pulse.

The raytracing along the laser pulse may be described using the aforementioned one or more selected coordinates (u, v).

The optical phase difference, OPD, may be defined for each location $x_i$, $y_i$. The OPD for a plurality of locations may be described in tensor form in (x, y | u, v) space as OPD (x, y | u, v). By obtaining the OPD, the effect of refractive index variations may thus be described.

In the following, we describe how the knowledge about the refractive index of the substrate of the mask can be used to improve the error correction.

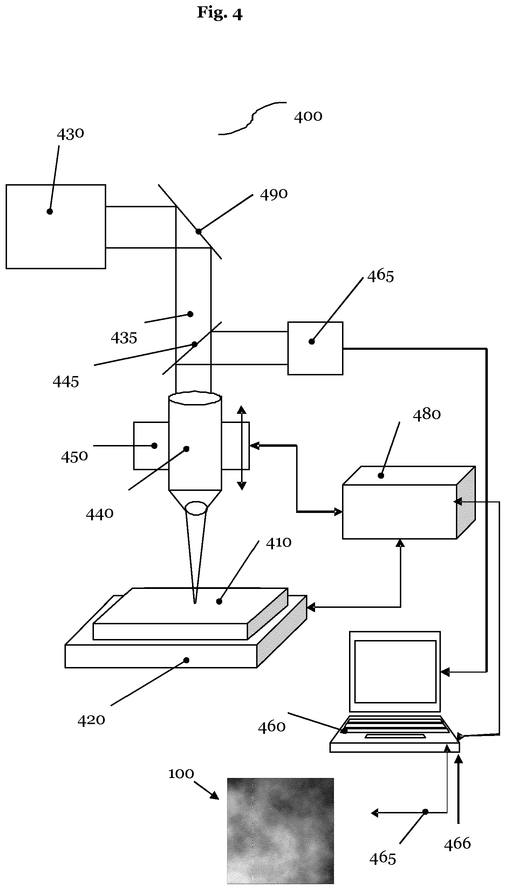

Fig. 4 depicts a schematic block diagram of an apparatus 400 according to an example. The apparatus 400 can be used to correct errors of a mask, for example the mask of Fig. 1. The apparatus 400 may comprise a chuck 420 which may be movable in three dimensions and/or three angles. The substrate of the mask 410 may be fixed to the chuck 420 by using various techniques, such as for example clamping. The apparatus 400 may include a laser source 430 which may produce a laser pulses 435. The laser source 430 may be able to generate laser pulses of a variable duration. The pulse duration may be as low as 10 fs but may also be increased up to 100 ps, e.g. in steps or continuously. However, other pulse durations are possible as well. The pulse energy of the light pulses generated by the laser source 430 can also be adjusted across a wide range, for example reaching from 0.01 mJ per pulse up to 10 mJ per pulse. Further, the repetition rate of the laser pulses may comprise the range from 1 Hz to 10 MHz. In some embodiments, the light pulses may be generated by a Ti:Sapphire laser operating at a wavelength of 800 nm. In other embodiments, the light pulses may be generated by a Yb HR: HHG laser. However, the methods described in the following are not limited to these values and this laser type. Principally, all laser types may be used, in particular laser types having a photon energy which is smaller than a band gap of the mask or the substrate of the mask 410 (or of any other element treated by the apparatus) and/or which are able to generate pulses with durations in the femtosecond range. Therefore, for example Nd:YAG laser or dye laser systems may also be used. The apparatus 400 may also comprise more than one laser source 430 (not shown in Fig.4). The laser pulses may be adapted such that the substrate of the mask is essentially transparent for the pulse wavelength. However, the laser pulses may be focused and have a sufficiently high density that, at a desired depth, a certain build-up occurs, such that a permanent material change is achieved, e.g. a local expansion of material that may depend on the focal shape.

In the example for Fig. 4, a steering mirror or steering system 490 directs the laser pulses 435 into a focusing objective 440. The objective 440 focuses the laser pulses 435 into the substrate of the mask 410. Properties of the apparatus 400, for example parameters of the applied objectives and laser parameters may be as those disclosed in WO 2013/030820 A1, for example. However, other parameters are also possible.

The apparatus 400 may also include a controller 480 and a computer system 460 which manage the translations and/or angles of the positioning stage of the chuck 420 and/or of the objective, such that the relative position may be controlled. In some examples, the controller 480 and the computer system 460 may control the translation of the objective 440 perpendicular to the plane of the chuck 420 (z direction). The relative x, y position may in turn be controlled via the position of the chuck. It should be further noted that manual positioning stages can also be used for the movement of the substrate of the mask 410 to the target location of the laser pulses 435 in the x, the y and the z direction and/or the objective 440 may have manual positioning stages for a movement in three dimensions. Other configurations to allow for a relative movement between the substrate of the mask 410 and the laser source 430 are possible as well.

Apparatus 400 may also provide an optional viewing system including a camera 465, such as a CCD (charge-coupled device) camera which may receive light from an illumination source via dichroic mirror 445. The viewing system may facilitate navigation of the substrate of the mask 410.

In one example, the apparatus 400 comprises means 465 for receiving a refractive index map 100 of the substrate of the mask. The refractive index map 100 of the substrate of the mask may be the refractive index map discussed with respect to Fig. 1. The apparatus 400 may further comprise means 466 for receiving mask error information, for example as part of computer system 460 or a different system (not shown). Based on the refractive index map and the mask error information, the apparatus may determine at least one first laser parameter for each of a plurality of laser pulses and/or a plurality of positions. This determining may be carried out by computer system 460 or a different system (not shown).

The apparatus 400 may then apply the plurality of laser pulses with the at least one first laser parameter for each pulse from the laser source 430 on the plurality of positions on the substrate of the mask 410. The application of the plurality of laser pulses may at least partially correct an error of mask 410. By taking into account the refractive index map 100 when determining the at least one first laser parameter for each of a plurality of laser pulses and/or the plurality of positions, the correction of the error of the mask may be improved compared to solutions which do not take the refractive index inhomogeneities of the substrate of the mask 410 into account.

Fig. 5 depicts a schematic block diagram of another exemplary apparatus 500. The apparatus 500 may correspond to the apparatus 400 described in Fig. 4 unless described otherwise below.

Computer 460 of apparatus 500 may be adapted for receiving and processing a refractive index map as outlined with reference to Fig. 4. However, this is not necessarily the case. Instead, computer 460 may simply be adapted to control the application of pulses that may be determined as in the prior art, and/or simply according to a pulse map externally provided to computer 460.

In addition to the components outlined with reference to Fig. 4, the apparatus 500 may comprise a pulse shaping unit 520. Notably, also the apparatus of Fig. 4 may comprise such pulse shaping unit, albeit not shown there.

The pulse shaping unit 520 may be adapted to vary each individual pulse. For example, the pulses may thus be corrected for the respective refractive index variation at the respective pulse position.

To allow that control, apparatus 500 may comprise means for receiving at least one first individual laser parameter for each laser pulse of the plurality of laser pulses to be applied at a plurality of corresponding positions on the substrate of the mask. The means may be a computer system 510, which may or may not be identical to computer system 460. Computer system 510 may then control pulse shaping unit 520 accordingly. Pulse shaping unit 520 may for example comprise a lens, adaptive optics, such as an adaptive or deformable mirror, etc. For example, a deformable mirror may be used that provides a stroke of up to about 90 $\mu$m deformation and/or a bandwidth of about 2 kHz, In some embodiments, a wave-front sensor, for example a Shack-Hartmann sensor may be used to monitor properties of the plurality of laser pulses. In some examples, a sensor may be used that provides an absolute RMS accuracy of about $\lambda$/100, a repeatability of about $\lambda$/100 or better, a pupil size of about 5 mm $\times$ 5 mm or more, and/or a frame rate of 100 Hz or more. The monitored properties may allow determining if a laser pulse has the at least one first individual laser parameter.

In addition or alternatively, computer system 510 may be adapted to receive a refractive index map 100, e.g. via a suitable interface 530. Based thereon, computer system 510 may determine the at least one first individual laser parameter for each laser pulse of the plurality of laser pulses to be applied at a plurality of positions.

As outlined, computer system 510 and computer system 460 may be realized by a single computer system. The pulse shaping unit 510 may also be controlled via a controller as intermediary to the respective computer, which may be controller 480 or a separate controller.

The pulse shaping unit 520 of Fig. 5 may generally be adapted for adapting each laser pulse of the plurality of laser pulses according to the at least one first individual laser parameter for the respective laser pulse. The pulse shaping unit 510 may adjust an amplitude and/or a phase of each individual laser pulse. This adjustment may be carried out based on decomposition weights $C_i$ for Zernike polynomials $Z_{ij}$ of a local OPD. An example for a decomposition will be detailed below. However, the adjustment may also be carried out based on other representations of the effect of the inhomogeneities of the refractive index of the substrate of the mask.

Thus, in one example, the pulse shaping unit 520 may be operated to at least partially compensate for the effects of an inhomogeneous refractive index of the substrate of the mask. In some examples, apparatus 500 may be used to improve a process agnostic to the refractive index map 100 of a surface, for example an error correction process carried out by computer system 460 of Fig. 5 which is not based on the refractive index map.

In the following we describe how representation by a Zernike polynomial basis may be advantageously used for example in the apparatus 400 of Fig. 4 and apparatus 500 of Fig. 5.

To represent an image I by means of decomposition weights $C_i$ for Zernike polynomials, the optimization problem for determining the decomposition weights $C_i$ may be formulated as follows:

$$min\left\|Z_{ij} \cdot C_i - I_j\right\|_F.$$

Here, F denotes the Frobenius norm; $Z_{ij}$ are Zernike polynomials of order i with image dimension index j. $I_j$ are image pixels and $C_i$ are the decomposition weights of the Zernike polynomials.

For the decomposition weights $C_i$ obtained by this optimization process, the achieved accuracy may be described in terms of error metrics. Namely, the following error metrics may be used:

$$RSS = \sum_j \left(I_j - Z_{ji} \cdot C_i\right)^2,$$

where RSS denotes a residual sum of squares.

Further, the following metric may be used:

$$TSS = \sum_j \left(I_j - \langle I_j \rangle\right)^2,$$

where TSS denotes the total sum of squares or variance.

Then the coefficient of determination, $R^2$, may be defined as:

$$R^2 = 1 - \frac{RSS}{TSS}.$$

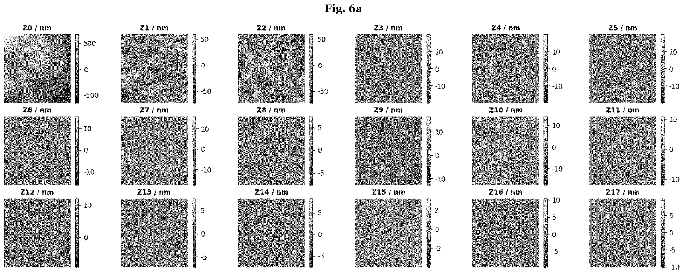

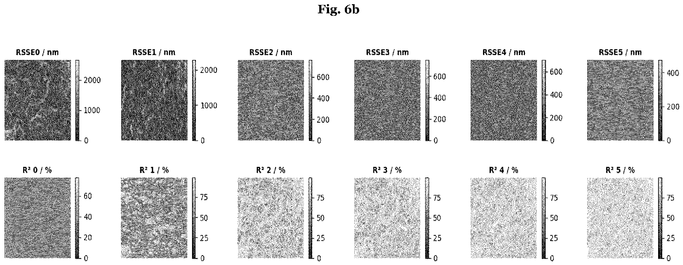

These measures may be used to determine to which order the decomposition in Zernike polynomials is required for a desired level of accuracy. This will be further detailed below with reference to Figs. 6a and 6b.

Fig. 6a shows a representation of the OPD residuals when using an approximation based on a Zernike decomposition using polynomials up to different orders denoted by Z0, Z1, Z2, ... to Z17. For example, in the plot denoted by Z0, that optical path difference of the experimental refractive index map that remains after approximating it by the o-th order Zernike polynomial is shown (this may be seen as a remaining error when using only a Zo-approximation). The unit in this graph is the optical path difference in nm. In the plot denoted with Z1, the remaining error when using a Z0 and Z1 approximation is shown. As can be seen, already with an approximation up to Z2, a very good approximation can be achieved, with an error below ±60 nm. This error can be reduced to below ±20 nm and ±10 nm, by using an approximation up to Z3 or Z8, respectively.

In this particular example, thus, an approximation up to Z2, Z3 or Z8 may be optimal, depending on the level of error that is considered acceptable.

Fig. 6b shows error metrics of the Zernike decomposition shown in Fig. 6a. The top row of Fig. 6b shows residual sum of squares error, RSS, when using Zernike polynomials up to order 0, 1, ... 4. The bottom row of Fig. 6b shows the corresponding coefficients of determination, $R^2$. As can be seen from top and bottom rows of Fig. 6b, the accuracy of the representation of the refractive index inhomogeneity by decomposition into Zernike polynomials increases with the order of the Zernike polynomials. For some examples, already relatively few coefficients, for example up to 4th order, for example up to 5th order, for example up to 6th order, for example up to 7th order, may suited for a representation of the inhomogeneity with the required accuracy.

Decomposition weights $C_i$ up to an order i which provides sufficient accuracy for the Zernike polynomials $Z_{ij}$ may be used, e.g. for optimization of pulse parameters and/or positions as described herein. Also, the decomposition wights up to $C_i$ may be directly used for the pulse shaping unit 520 explained with reference to Fig. 5 which may be configured based on the decomposition weights to compensate for them. This may simplify the optics and/or control circuity for the pulse shaping unit 520 and/or increase throughput of the apparatus 500.

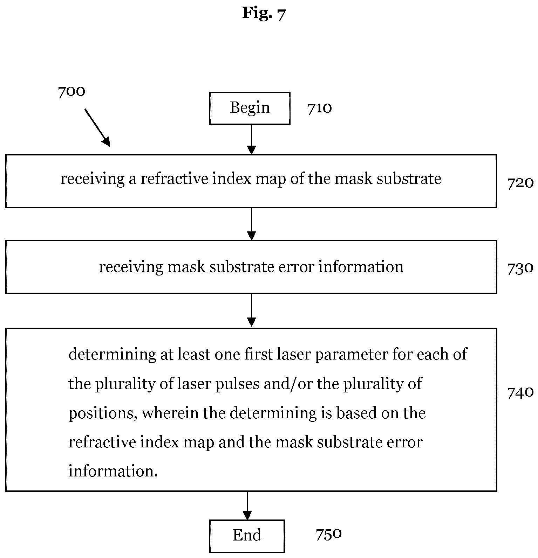

Fig. 7 shows a method according to the first example. The method 700 for correcting an error of a mask using a plurality of laser pulses applied on a plurality of positions on the substrate of the mask begins at 710. In step 720, a refractive index map of the substrate of the mask is received. In step 730, mask error information is received. The mask error information may comprise deformation information and/or alignment information, e.g., as described herein.

In step 740, at least one first laser parameter for each of the plurality of laser pulses and/or the plurality of positions is determined. For example, a first laser parameter resulting in a laser focus as shown in Fig. 2a and Fig. 2b is determined. The determining in step 740 may be based on the refractive index map and the mask error information. By taking into account both the refractive index map and the mask error information, at least a partial correction of the error of the mask may be achieved even for substrates of masks with inhomogeneous material properties, in particular inhomogeneous refractive index.

In some examples, for a first set of second laser parameters (e.g. a first focal shape at a certain depth), a first set of optimized pulse positions may be determined. For a second set of second laser parameters (e.g. a second focal shape at a certain (different) depth), a second set of optimized pulse positions may be determined. Generally, for an n-th set of second laser parameters, an n-th set of optimized pulse positions may be determined. Thus, various pulse types may be uniformly applied to the substrate of the mask, such that they, in combination, optimally repair the error, taking into account the refractive index map.

**Claims**

1.  A method (700) for correcting an error of a mask using a plurality of laser pulses applied on a plurality of positions on a substrate of the mask, the method comprising:

    receiving (720) a refractive index map of the mask substrate,
    receiving (730) mask error information,
    determining (740) at least one first laser parameter for each of the plurality of laser pulses and/or the plurality of positions,
    wherein the determining is based on the refractive index map and the mask error information.

2.  The method of claim 1, further comprising:
    applying the plurality of laser pulses with the at least one first laser parameter for each pulse on the plurality of positions on the substrate of the mask.

3.  The method of claim 1 or claim 2, further comprising:

    receiving at least one second laser parameter for each of the plurality of laser pulses, and wherein the at least one first laser parameter and/or the plurality of positions is further determined based on the at least one second laser parameter.

4.  The method of any of claims 1-3, further comprising:

    receiving a second plurality of positions on the substrate of the mask, and
    wherein the plurality of positions and/or the at least one first laser parameter is further determined based on the second plurality of positions.

5.  The method of any of claims 1-4, wherein determining the at least one first laser parameter further comprises:
    determining, for each position $(x, y)$ of the plurality of positions and/or of the second plurality of positions, a local optical path difference, OPD, wherein the local OPD is caused by deviations in the refractive index map from an average refractive index of the substrate of the mask.

6.  The method of claim 5, wherein the determining the local OPD includes raytracing of a laser pulse to be applied on the respective position based on the refractive index map.

7.  The method of claim 5 or 6, wherein for each position $(x, y)$, the determining of the local OPD includes integrating the local phase difference for a plurality of local pulse coordinates around a center of each pulse, acquired by propagation from that local pulse coordinate to a corresponding focal depth $z_0$ within the substrate of the mask.

8.  The method of claim 6 or claim 7, wherein the raytracing for determining the OPD is at least in part based on the formula

$$OPD(x,y) = \int \Delta n(x,y)ds$$

,

    wherein $n_0$ is an average refractive index of the substrate of the mask,
    $\Delta n$ is the refractive index map describing a deviation of a local refractive index from the average refractive index and
    wherein the differential ds is the differential along the ray path obtained via the raytracing of the laser pulse.

9.  The method of any of claims 5-8, wherein each local OPD comprises a set of decomposition weights ($C_i$) for Zernike polynomials ($Z_{ij}$).

10. The method of any of claims 1-9, further comprising: wherein the at least one laser parameter comprises a configuration for a first optical component for applying each of the laser pulses, such as to adjust an amplitude and/or a phase of that laser pulse to at least partially compensate an inhomogeneous refractive index of the substrate of the mask.

11. A method for correcting an error of a mask using a plurality of laser pulses on the substrate of the mask, the method comprising:

receiving at least one laser parameter of the plurality of laser pulses,
receiving a refractive index map of the substrate of the mask, determining, for a plurality of positions (x, y) on the substrate of the mask, a local optical path difference, OPD, based on the at least one laser parameter,
wherein the local OPD is caused by deviations in the refractive index map from an average refractive index of the substrate of the mask.

12. A computer program comprising instructions which, when the computer program is executed by a computer, cause the computer to carry out the steps of the method of any of claims 1-11.

13. An apparatus (400) for correcting an error of a mask having an inhomogeneous refractive index, the device comprising:

means for receiving a refractive index map of a substrate of the mask,
means (466) for receiving mask error information,
means for determining at least one first laser parameter for each of a plurality of laser pulses and/or a plurality of positions,
wherein the determining is based on the refractive index map and the mask error information.

14. An apparatus (500) for correcting an error of a mask, comprising:

a laser source (430) for directing a plurality of laser pulses on a plurality of corresponding positions on a substrate of the mask;
means (510) for receiving at least one first individual laser parameter for each laser pulse of the plurality of laser pulses to be applied at a plurality of corresponding positions on the substrate of the mask;
a pulse shaping unit (520) adapted for adapting each laser pulse of the plurality of laser pulses according to the at least one first individual laser parameter for the respective laser pulse.

15. The apparatus of claim 13 or 14, further comprising means to carry out the method according to any of claims 1-11.

Fig. 1

**Fig. 2a**

Fig. 2b

Fig. 3

**Fig. 4**

**Fig. 5**

Fig. 6a

**Fig. 6b**

**Fig. 7**

700

| Begin | 710

receiving a refractive index map of the mask substrate — 720

receiving mask substrate error information — 730

determining at least one first laser parameter for each of the plurality of laser pulses and/or the plurality of positions, wherein the determining is based on the refractive index map and the mask substrate error information. — 740

| End | 750

Europäisches
Patentamt

European
Patent Office

Office européen
des brevets

# EUROPEAN SEARCH REPORT

**Application Number**

**EP 24 22 1119**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/084044 A1 (DMITRIEV VLADIMIR [IL]) 5 April 2012 (2012-04-05) | 1-4,10, 12,13,15 | INV. G03F1/60 |
| A | * paragraphs [0009] - [0011], [0044] - [0046], [0056], [0068], [0106] - [0117]; figures 7, 8, 9 * | 5-9 | G03F1/72 G03F1/84 |
| A | US 2019/170991 A1 (SEESSELBERG MARKUS [DE] ET AL) 6 June 2019 (2019-06-06) * paragraphs [0002] - [0007], [0088] - [0089]; figure 3 * | 5-9 | |

-----

-----

**TECHNICAL FIELDS SEARCHED (IPC)**

G03F

The present search report has been drawn up for all claims

| Place of search | Date of completion of the search | Examiner |
|---|---|---|
| The Hague | 21 February 2025 | Apel, Lea |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**Application Number**

EP 24 22 1119

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-10, 13(completely); 12, 15(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

**Application Number**

**EP 24 22 1119**

The Search Division considers that the present European patent application does not comply with the requirements of unity of invention and relates to several inventions or groups of inventions, namely:

```
1. claims: 1-10, 13(completely); 12, 15(partially)

    taking intrinsic material properties of the mask blank and
    the patterned mask into consideration when determining a
    correction for a mask.
                         ---

2. claims: 11(completely); 12(partially)

    facilitate the determination of mask error corrections.
                         ---

3. claims: 14(completely); 15(partially)

    repair a mask error by using a laser
                         ---
```

## ANNEX TO THE EUROPEAN SEARCH REPORT
## ON EUROPEAN PATENT APPLICATION NO.

EP 24 22 1119

This annex lists the patent family members relating to the patent documents cited in the above-mentioned European search report.
The members are as contained in the European Patent Office EDP file on
The European Patent Office is in no way liable for these particulars which are merely given for the purpose of information.

21-02-2025

| Patent document cited in search report | | Publication date | Patent family member(s) | | Publication date |
|---|---|---|---|---|---|
| US 2012084044 | A1 | 05-04-2012 | DE | 102011083774 A1 | 05-04-2012 |
| | | | JP | 5684688 B2 | 18-03-2015 |
| | | | JP | 2012088712 A | 10-05-2012 |
| | | | KR | 20120035124 A | 13-04-2012 |
| | | | US | 2012084044 A1 | 05-04-2012 |
| US 2019170991 | A1 | 06-06-2019 | CN | 109416507 A | 01-03-2019 |
| | | | DE | 102016214695 B3 | 19-10-2017 |
| | | | JP | 7296412 B2 | 22-06-2023 |
| | | | JP | 2019532350 A | 07-11-2019 |
| | | | JP | 2021076853 A | 20-05-2021 |
| | | | KR | 20190022876 A | 06-03-2019 |
| | | | KR | 20210152019 A | 14-12-2021 |
| | | | TW | 201816505 A | 01-05-2018 |
| | | | US | 2019170991 A1 | 06-06-2019 |
| | | | WO | 2018029184 A1 | 15-02-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102011083774 A1

- WO 2013030820 A1